# EUROPEAN PATENT SPECIFICATION

(11) **EP 1 590 721 B1**
(45) Date of publication and mention of the grant of the patent: **11.04.2007**
(21) Application number: 04705146.1
(22) Date of filing: 26.01.2004
(51) Int. Cl.: G06F 1/00

(54) **ELECTRONIC DEVICE**
ELEKTRONISCHE VORRICHTUNG
DISPOSITIF ELECTRONIQUE

(30) Priority: 28.01.2003 EP 03100177
(43) Date of publication of application: 02.11.2005
(73) Proprietor: Koninklijke Philips Electronics N.V., 5621 BA Eindhoven (NL)
(72) Inventor: DE LEEUW, Dagobert, M., NL-5656 AA Eindhoven (NL); MEIJER, Eduard, J., NL-5656 AA Eindhoven (NL); SETAYESH, Sepas, NL-5656 AA Eindhoven (NL)
(74) Representative: van Loon, C.J.J.
(86) International application number: PCT/IB2004/050053
(87) International publication number: WO 2004/068267

(56) References cited:
- WO-A-99/10939
- US-A- 5 596 208

## Description

The invention relates to an electronic device comprising a first and a second field-effect transistor with a source and a drain electrode, which electrodes are separated from each other by an active layer containing an organic material, which active layer is common to the first and the second transistor, at which a gate electrode is present that is separated from the active layer by a dielectric layer.

The invention additionally relates to a method of manufacturing an electronic device comprising a first and a second field-effect transistor with a common active layer containing an organic p-type semi-conductor material, which active layer is applied to a substrate from a solution.

Such a device and such a method are known from WO-A 99/10939. The known device comprises a field-effect transistor which is entirely made of organic material. The source and drain electrode are then located in a first electrically conductive layer and the gate electrode is located in a second electrically conductive layer. The active layer contains an organic semi-conductor material, such as poly-2.5-thienylenevinylene. The semi-conductor material is not doped, at least not knowingly, and shows a p-type charging behavior.

A disadvantage of the known device is that such a device with unipolar logics must be connected to an inverter unit. In unipolar logics such a unit comprises two transistors whose drain electrodes are interconnected, and in which the gate of one transistor, the load transistor, is electrically connected with the drain electrodes. The drain electrodes are then connected with the output of the inverter, the source electrode of the load transistor to the supply voltage V_{dd}, the gate electrode of the second, driver, transistor is connected with the input, and the source electrode of the control transistor is grounded.

The disadvantage of such unipolar logics lies inter alia in the fact that the gain of the inverter is limited. The gain is here defined as the change of the output voltage as a function of the input voltage. A normal gain is in the order of 1.2 to 2. Seeing that logics based on inverters no longer function with a gain of 1 or less, this gain is barely adequate for the functioning of the logics. The consequence of this is a small noise margin. The margin is often so small that it is difficult to distinguish a high voltage from a low voltage. The difference between high and low in digital circuits corresponds to a difference between 1 and 0, in other words to either a result or no result.

Thus it is an object of the invention to produce a device of the type mentioned in the introduction in which the inverter unit has a higher gain and a better noise margin.

This object is achieved in that the device includes an inverter unit with a first and a second field-effect transistor, which each include a source and a drain electrode, which electrodes are located in the same electrode layer of electrically conductive material. A pair of a source and a drain electrode (in one transistor) is therein interconnected by a first channel with an n-type conductivity and by a second channel with a p-type conductivity, which channels are located in an active layer that contains organic semi-conductor material. Each of the transistors includes a gate electrode that is separated from the channels by a dielectric layer.

According to the invention use is made of transistors of the type known as ambipolar. These transistors may serve both as a p-type transistor and as an n-type transistor. Experiments have shown that much higher gains and higher noise margins can be achieved in this way. In early experiments a gain of 10 was measured. The inverter unit according to the invention then functions in a surprisingly positive manner in two aspects.

Firstly, it is surprising that one and the same electrical conductor is suitable as electrode material for both the n-type and the p-type transistors. It is a normal starting point that for n-type materials an electrically conductive material with a low work function is to be used. Examples of this are Al, Ba and Ca, which metals are used for the cathode in organic diodes. In the invention only a single electrode material is used, and yet no unbridgeable gaps between the electrode material and the active layer are found.

It is obvious that use of the same electrode material for all source and drain electrodes has great advantages for the production of the device. A separate metal layer must always be applied with a separate deposition and patterning step. Moreover, not all metal layers are compatible and for the different metal layers different adhesive layers are applied. Obviously, the electrically conductive layer can comprise various layers. Particularly favorable materials are precious metals, but also organic conductors such as poly-3,4-ethylenedioxythiophene (PEDOT) and oxidic conductors such as indium tin oxide (ITO) are applicable.

Secondly, it is surprising that a single active layer of organic material is suitable for both n-type and p-type transport of charge carriers, without any occurrence of substantial hindrance or self-leveling of the p-type transport by constituents responsible for the n-type transport. This is expressed in that a first and a second channel are present in the active layer, while it is not excluded that these channels partly overlap in the chemical sense. That the active layer is common to the first and the second transistor implies that the active layer of the transistors is applied in a single deposition step and thus in principle has the same composition. Preferably, the active layer is also uninterrupted between the first and the second transistor. The fact that both channels are located in one active layer does not exclude that this one layer is applied as a number of sub-layers which each permit n-type and p-type transport.

It is noted that an active layer with in this instance a blend of polyphenylenevinylene and buckminsterfullerene has a known use in solar cells. In a solar cell the active layer is used to receive light and to convert a photon into an electron and a hole, which holes are subsequently transported to the electrodes. This creates simultaneous transport of electrons and holes in opposite directions. Nothing shows that the same material is suitable as a semi-conductor material, such that in combination with source and drain electrodes of one and the same electrically conductive material, p-type conductivity is obtained in the event of negative voltages on the gate electrode (V_{g}) and between source and drain electrode (V_{sd}) and n-type conductivity in the event of positive voltages on the gate electrode and between source and drain electrode. The inverter unit with this active layer proves to have good gain and, moreover, little hysteresis.

The fact that no substantial hindrance occurs implies also that no substantial parasitic currents arise. This means: in circumstances in which there is p-type conductivity, the parasitic current through the first channel with n-type transport is very small. This has the great advantage that the active layer is thus also applied, where only a single-polarity semi-conductor is required. One might think here in particular of a combination of a screen with pixel transistors and the integrated circuit for the driving (the driver IC); where in the pixel transistors a single polarity is sufficient, both polarities are used in the driver IC. So this leads to driver IC and screen being produceable in integrated fashion.

Obviously, the device according to the invention may also be suitable for other applications; in particular for memory circuits, such as SRAM and DRAM, for ring oscillators, for identification purposes, etc., as is known to the specialist in the field of circuitry.

In an advantageous embodiment a common gate electrode is present for the first and the second transistor. In the inverter unit according to the invention basically the gate electrodes of the transistors are interconnected and form in coupled fashion the input electrode for the inverter. Also the drain electrodes of the transistors are intercoupled in the inverter, but not connected with the gate electrode. The advantage of a common gate electrode is that fewer parasitic effects occur. Between neighboring transistors there are, as a rule, parasitic capacitances and currents, which are only limited by placing the transistors a sufficient distance apart. By using a single gate electrode, the surface and thereby the interaction with other elements in the device is reduced. Another advantage is that the absence of an interconnect between the gate electrodes reduces the resistance. This is particularly important with the use of organic conductors. Moreover, the requirements for the lithographic structuring of the gate electrodes is less stringent in comparison with unipolar logics seeing that several transistors use the same gate electrode.

In a further embodiment the drain electrodes of the first and second transistor are common; that is to say that there is only one single drain electrode. This is particularly advantageous whenever the source and drain electrodes form an interdigitated electrode pair, the source electrodes being mutually protected by intermediate parts of the drain electrode. The use of an interdigitated electrode pair is advantageous in that a greater channel width is achieved, whereas the surface of the transistor or the inverter does not increase accordingly. It is self-evidently simple to enlarge the finger-like structure of the drain electrode, so that both source electrodes connect to it. The source electrodes, however, are not on the same voltage, which might lead to parasites and uncontrollable effects. In order to prevent this, the source electrodes are mutually screened by intermediate parts of the drain electrode. In this way the parasitic effects are controllable.

The screening by the drain electrode is achieved for example in that two or more finger-like structures of the drain electrode are present between the source electrodes. However, the drain electrode preferably has a body with a first side and a second side turned away from this first side, which body on the first and second side has a finger-like structure. The source electrode is then located on the first side and forms an interdigitated electrode pair with the finger-like structure on this first side. The drain electrode is located on the second side and forms an interdigitated electrode pair with the finger-like structure on this second side. The result is not only a good screening, but also the fact that the resulting inverter unit can have an essentially rectangular form. This is a compact form, and additionally has the advantage that the overlay accuracy in relation to the gate electrode is less problematic. Deviations in the overlay lead to side effects in the operation of the transistors.

Particularly suitable as active layers are those layers that can be applied to a substrate from a solution, for example, by means of spraying, spin-coating or printing. The use of such techniques is particularly desirable for application in flexible devices. Layers which are applied with the help of chemical vapor deposition are generally crystalline. Any bending of the device can very quickly lead to failure. A disadvantage associated with chemical vapor deposition for this sort of application is that it must take place in a vacuum, which is disadvantageous for production on an industrial scale.

Examples of active layers which are applied from a solution include functionalized materials, materials on the basis of a carrier material and precursor materials. Advantageous examples are in particular polyfluorenes, such as poly(3,9-di-tert-butyllindeno[1,2-b]fluorene), and blends of functionalized n-type semi-conductor materials and functionalized p-type semi-conductor materials. Examples of p-type materials are inter alia polythiophenes, polythienylene-vinylenes, polyarylamines, polyphenylene-vinylenes, pentacene and similar oligomers. Examples of n-type materials are inter alia blends of TCNQ-TTF, such as are known from W095-31833, and materials on the basis of fullerenes, also known as C₆₀ and C₇₀ materials and derivatives of these. Particularly favorable here as esters are functionalized variants of these, such as [6,6]-phenyl C₆₁-butyric acid methyl ester. This material is known per se from Hummelen et al., *J.Org. Chem.,***60** (1995), 532.

With blends the use of functionalized materials is extraordinarily advantageous; non-functionalized materials are often poorly soluble. The alternative consists in the use of precursor materials. These precursors must however, after application, be still converted into the actual semi-conductor materials by treatment at increased temperature. Since the temperature treatments of various materials do not readily take place at the same temperature, this endangers the stability of the compounds.

It is noted that also copolymers of said and other compounds are applicable. It may also be that such copolymers are combined to networks.

When blends are used it is advantageous when the n- and p-type semi-conductor materials have a mobility µₙ, µₚ and a mutual relationship µₙ:µₚ in the range from 0.1 to 10. In these circumstances both transistors in the inverter unit could be identical; this simplifies the design of the device with the inverter unit, and reduces the chance of parasitic and unexpected effects.

In a further embodiment the active layer includes a blend of an organic carrier material, the p-type semi-conductor material and the n-type semi-conductor material. This blend has the advantage that it can be very well applied from the solution, thus by spin coating, printing, web coating or any other comparable technique. A further advantage is that the active layer appears to have a surprisingly good stability in this way. At the same time the mobility in the channels is scarcely less than with an active layer without carrier material, although the concentration in semi-conductor material is much lower. Examples of suitable carrier materials are inter alia polyvinyl compounds, such as polyethylene, polypropylene, polystyrene; polyimides, polyesters, such as polymethylmethacrylate, polyethyleneterephtalate, polyetyhleneglycoldimethacrylate; polyvinyl alcohols. The carrier materials have preferably a glass transition temperature of more than 100°C, and with this the stability of the carrier material is guaranteed in a variety of conditions of production and use.

A variety of materials can be applied as a dielectric layer. Experiments have shown that the ambipolar transistor functions with both a dielectric layer of an inorganic material such as SiO₂ and a dielectric layer of an organic material such as polyimide, polyacrylate or a photoresist.

It is a second object of the invention to provide a method with which an inverter having improved gain can be applied with the help of solution processing.

This second object is achieved in that the electronic device comprises an inverter unit having a first and a second field-effect transistor and a common active layer containing a functionalized organic n-type semi-conductor material and a functionalized organic p-type semi-conductor material, which active layer is applied from a solution to a substrate. The method of operation achieves an inverter structure of the ambipolar type having good properties which, however, is produceable in an inexpensive and industrially viable manner. The method is applicable with all above-mentioned materials and variants, and further variants which are known to a man of skill in the art.

This and other embodiments of the device according to the invention will be explained below on the basis of the following figures, where
Fig. 1 shows a diagrammatic cross-section of the device;
Fig. 2 shows the connection between the voltage V_{ds} between the source and drain electrode and the resulting current I_{ds} at different voltages V_{g} on the gate electrode in the ambipolar transistor applied in the invention having a blend of an n-type and a p-type semi-conductor material as an active layer;
Fig. 3 shows the connection between the voltage V_{ds} between the source and drain electrode and the resulting current I_{ds} at different voltages V_{g} on the gate electrode in a unipolar transistor with only an n-type semi-conductor material;
Fig. 4 shows an electrical diagram of an inverter unit;
Fig. 5 shows the connection between the input voltage V_{IN} and the output voltage V_{OUT} of the inverter according to the invention;
Fig. 6 shows a diagrammatic plan view of a second embodiment of the inverter according to the invention, and
Fig. 7 shows the connection between the voltage V_{ds} between the source and drain electrode and the resulting current I_{ds} at different voltages V_{g} on the gate electrode in the ambipolar transistor applied in the invention having as an active layer a single semi-conductor material with a small bandgap.

### Example of embodiment 1

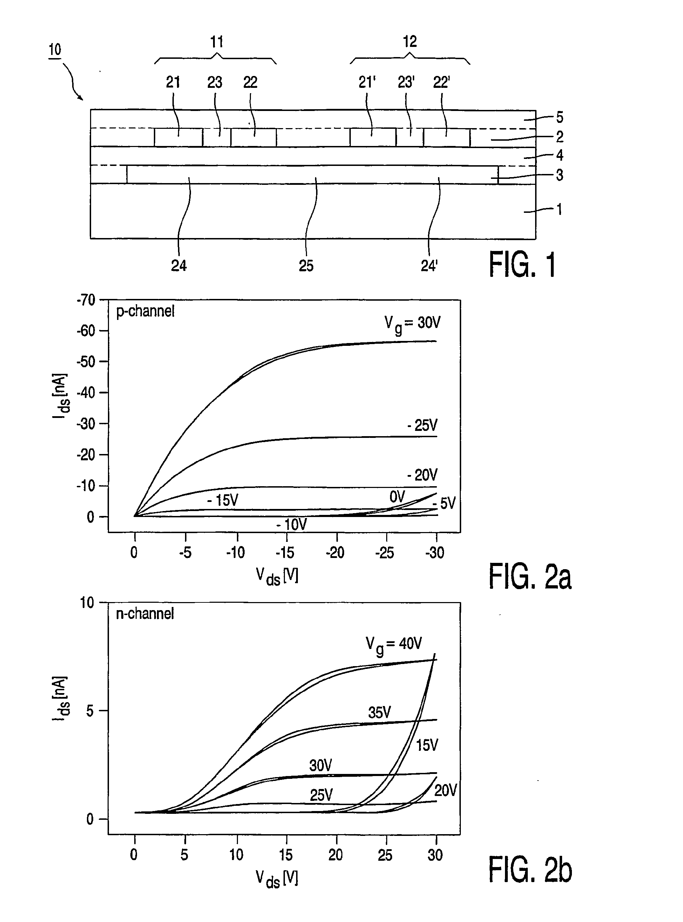

The inverter 10 shown in Fig. 1 comprises a first field-effect transistor 11 and a second field-effect transistor 12. The inverter 10 comprises an electrically insulating substrate 1. A first electrode layer 2 and a second electrode layer 3 are present on the substrate 1. In the first electrode layer 2 source electrodes 21, 21' and drain electrodes 22 22' are defined, which electrode pairs 21, 22 and 21', 22' are separated from one another by a channel 23, 23', respectively. In the second electrode layer 3 gate electrodes 24, 24' and an interconnect 25 interconnecting them are defined. In a vertical projection of the gate electrode 24 on the first electrode layer 2 the gate electrode 24 substantially overlaps the channel 23. In addition, an intermediate layer 4 and an active layer 5 are present.

The above-mentioned layers 2,3,4,5 are present in the order of second electrode layer 3, intermediate layer 4, first electrode layer 2 and active layer 5 on the substrate 1. In order to planarize the substrate, an insulating planarization layer-not shown - is present made of, for example, polyvinyl alcohol or a photoresist. The second electrode layer 3 contains Au and is brought into a desired pattern in a known manner with the help of an exposed and developed photo-sensitive resist. Between the second electrode layer 3 and the intermediate layer 4 may be inserted a monolayer - not shown - of CH₃-(CH₂)₁₅-SH to prevent pinholes in the intermediate layer 4. The intermediate layer 4 contains in general a photostructurable organic dielectric, such as benzocyclobutene, polyimide, polyvinylphenol or a photoresist, such as SU8. The intermediate layer may also contain an inorganic dielectric, such as for example SiO₂, which was the case in a first experiment. In a second experiment the photoresist SU8 was applied as an intermediate layer. The first electrode layer 2 contains gold in this case. The first electrode layer 2 is applied by means of spin coating and structured by exposure.

The first electrode layer 2 is covered by the active layer 5 by means of spin coating to a depth of 50 nm. The active layer 5 contains a blend of [6,6]-phenyl C61 butyric acid methylester and poly [2-methoxy, 5-(3,7 dimethyl-octyloxy]-p-phenylene vinylene, which polymer is also known as OC₁OC₁₀-PPV. The ratio in the blend is 4:1. The active layer is applied to the semi-conductor material as a solution in chlorobenzene with a content of 0.5 per cent by weight. The solution was prepared by stirring at 80°C for one hour and subsequently cooling down to room temperature.

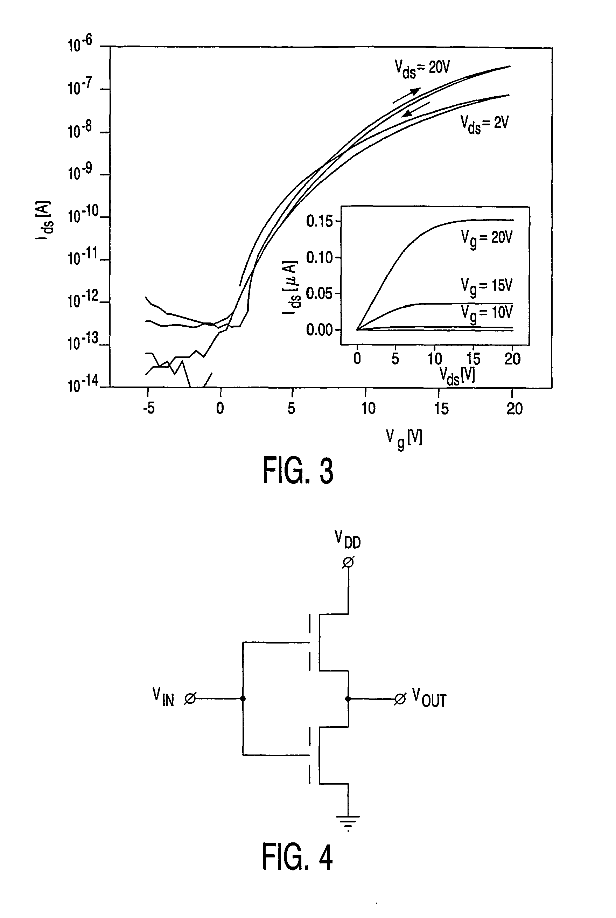

Fig. 2 and Fig. 3 show measurement results of measurements done on comparable transistors. Fig. 2 shows the data for a transistor with an active layer of the blend described above of [6,6]-phenyl C61 butyric acid methylester and OC₁OC₁₀-PPV in a mutual 4:1 ratio. Fig. 3 shows a graph of a comparable transistor, in which [6,6]-phenyl C61 butyric acid methylester is applied as a semi-conductor material, that is to say, only the n-type material. The graphs are based on measurements on a typical test device, where the gate electrode 24 is located in a silicon substrate. The surface of the substrate 1 is then oxidized to silicon dioxide, which forms the dielectric layer 4. On this layer are placed the source and drain electrodes 21, 22 of Au. On top of this is found the active layer 5. The channel length was then 40 µm and the channel width 1 mm. The SiO₂ layer was treated with a primer, which was hexamethyldisilazane (HMDS).

Fig. 2 shows graphs in which the current I_{ds} is plotted in nA against the voltage between the source and drain electrodes V_{ds} for various gate voltages V_{g}. For high negative voltages V_{g} on the gate electrode, as shown in Fig 2(a), the transistor is in the "hole enhancement mode". The characteristics of the transistor are here identical to a unipolar transistor of the semi-conductor material OC₁OC₁₀-PPV. At low voltages on the gate and high voltages on the drain V_{ds} the current I_{ds} shows a noticeable rise with the voltage on the drain V_{ds}. This is a typical characteristic of the ambipolar transistor and is not present in the comparable unipolar transistor.

At positive voltages V_{g} on the gate electrode, as shown in Fig. 2(b), the transistor operates in the "electron-enhancement mode", with a mobility of 3. 10⁵ cm²/Vs at V_{g}=30 volts. At low voltages on the drain V_{ds} a non-linear increase of the current is noticeable. For low voltages on the gate V_{g} and high voltages on the drain V_{ds} again a noticeable increase is found in the current, which is typical of the ambipolar transistor. This increase of the current is attributed to the fact that under certain conditions both holes and electrons are present in the transistor, so that a p-n-junction is formed in the channel.

When the transistor is in the "hole accumulation mode" the current can be described with a model based on the hopping of charge carriers in an exponential density of states (DOS), as is known from Phys.Rev.B 57, 12964 (1998). For the description of the n-type conductivity injection-limited current is considered. In the case of an increase of V_{ds} to the point where V_{ds} equals V_{g}-Vₛₒ (the switch-on voltage), the channel is cut off at the drain electrode. For still greater drain voltages V_{ds} a depletion region around the drain electrode will develop in unipolar transistors and the current will saturate. For an ambipolar transistor, however, the electrodes accumulate at the drain electrode in case of a further rise of the drain voltage V_{ds}. These two accumulation regions provide for the occurrence of a pn-junction. The current I_{ds} between source and drain can subsequently be calculated, provided that the current at the pn-junction cannot change, and provided that the combined lengths of the electron accumulation region and the hole accumulation region are equal to the channel length. It follows from this that the current I_{ds} consists of the sum of the currents of holes and electrons. The ambipolar transistor can thus physically be considered a p-type and an n-type transistor which are connected in parallel.

Fig. 4 shows an electrical diagram of the inverter according to the invention.

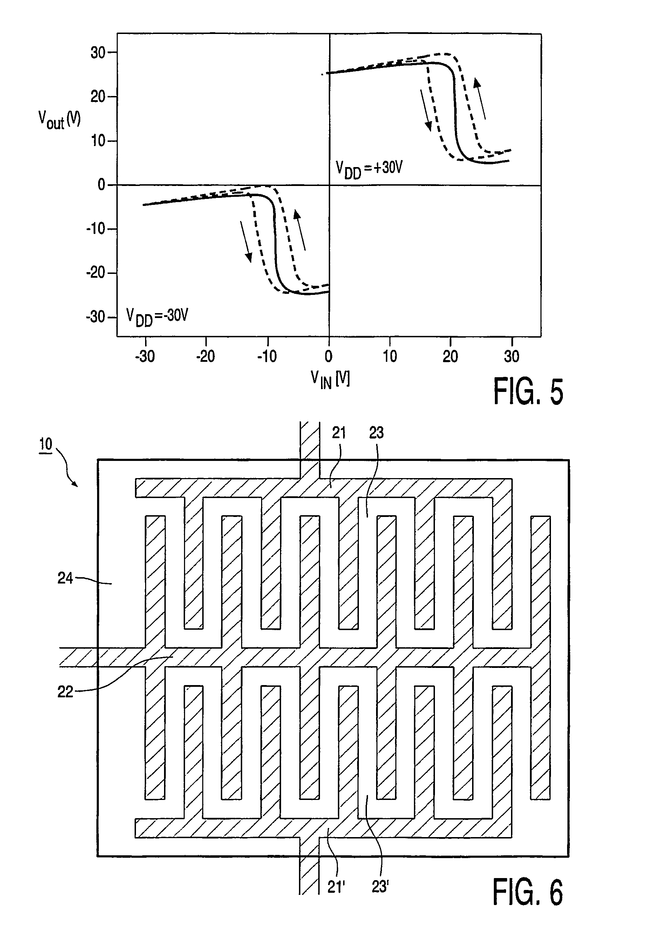

Fig. 5 shows the transfer characteristics of the inverter according to the invention, where two identical transistors are applied. The applied transistors have an active layer with a blend of [6,6]-phenyl C61 butyric acid methylester and of OC₁OC₁₀-PPV. The applied transistors are described with reference to Fig. 2. Depending on the polarity of the supply voltage V_{DD}, the inverter operates according to the invention in the first or the third quadrant. An inverter based on unipolar logics, on the other hand, operates only in the first quadrant. Moreover, a small increase in the output voltage Vₒᵤₜ can be observed at low and at high values of the input voltage V_{IN}. This increase is attributed to the fact that both transistors function as a parallel circuit of an n-type and a p-type transistor. Both at a high and at a low input voltage V_{IN} the inverter can, however, still draw some current. This results in the increase of the output voltage V_{OUT} found. The properties of the inverter can be modelled with a density of state (DOS) approach. This leads to the behavior that is shown in the graph in a black line. Moreover, it is remarkable that the graph of V_{OUT} versus V_{IN} has a considerably symmetrical position in the quadrant. This is advantageous in that the trip voltage - the voltage at which the value of the input voltage V_{IN} equals the value of the output voltage V_{OUT} -lies midway between the input voltage with a minimum output and the input voltage with a maximum output. As a result, the noise margin is optimal. With unipolar logics, on the other hand, the trip voltage deviates from said middle value, so that a further reduction of the noise margin is achieved.

Fig 6 shows in plan view a second embodiment of the inverter 10 according to the invention. Here a common gate electrode 24 is applied, and the source and drain electrodes 21,22 are executed in a interdigitated finger-like structure. This leads to a broad channel 23, 23' on a limited surface. The drain electrode 22 is then shared by the source electrode 21 of the first transistor and the source electrode 21' of the second transistor.

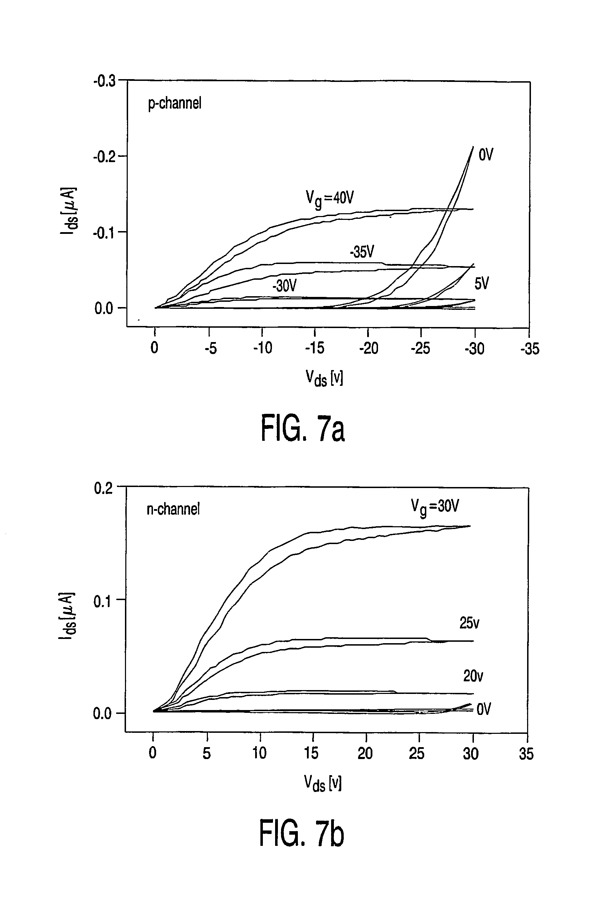

Fig. 7 shows the characteristics of an ambipolar field-effect transistor, in which a material with a small band gap is used as an active layer. In this example use is made, although this is not essential, of poly(3,9-di-tert-butyllindeno [1,2-b] fluorene, which is also indicated as PIF. The PIF material was dissolved in chlorobenzene in a concentration of approximately 1%, and applied with the help of spin coating to the surface of test devices. The test devices are described with reference to Fig. 2. After the spin coating the devices were heated to 90°C in vacuum. The graphs show that we are dealing here with an ambipolar transistor. The mobility obtained is approximately 2.10⁻⁵ for holes and for electrodes.

As a man of skill in the art will understand, materials other than the above-mentioned can be used too. Moreover, it holds that the device can include more elements than just the inverter. A number of inverters can for example be connected in series, while forming a ring oscillator. The inverters may also be part of NAND or NOR units. The transistors can be executed with another dimensioning, for example with smaller channel lengths or with larger channel widths. Thus the invention provides an inverter unit based on transistors with a first channel of the first conductivity type and a second channel of the second conductivity type, which channels are located in a single active layer, and where only a single electrode layer is applied.

## Claims

1. Electronic device comprising an inverter unit 10 with a first 11 and a second field-effect transistor 12 which each include a source (21, 21') and a drain electrode (22, 22') which electrodes of the field-effect transistors are located in the same electrode layer (2) of electrically conductive material and which pair of source and drain electrodes is interconnected by a first channel (23) with an n-type conductivity and by a second channel with a p-type conductivity (23), which channels are located in one active layer which contains organic semi-conductor material and which is common to the first and the second transistor, each of the transistors comprising a gate electrode (24, 24') which is separated from the channels by a dielectric layer (4).

2. Electronic device as claimed in claim 1, **characterized in that** a common gate electrode is present for the first and the second transistor.

3. Electronic device as claimed in claim 1 or 2, **characterized in that** the drain electrodes of the first and the second transistor are common.

4. Electronic device as claimed in claim 3, **characterized in that** the source and drain electrodes form an interdigitated electrode pair, in which the source electrodes are mutually protected by intermediate parts of the drain electrode.

5. Electronic device as claimed in claim 4, **characterized in that that** the drain electrode comprises a body with a first side and a second side turned away from this first side, which body on the first and the second side has finger-like structures, the source electrode being located on the first side and together with the finger-like structure on this first side forming an interdigitated electrode pair and the drain electrode being located on the second side and together with the finger-like structure on this second side also forming an interdigitated electrode pair.

6. Electronic device as claimed in claim 1, **characterized in that** the active layer contains a blend of an organic carrier material, the p-type semi-conductor material and the n-type semi-conductor material.

7. Electronic device as claimed in claim 1, **characterized in that that** the source and drain electrode comprise a material chosen from the group of precious metals.

8. Electronic device as claimed in claim 1, **characterized in that** the n- and p-type semi-conductor materials have a mobility µₙ, µₚ with a mutual µₙ:µₚ ratio in the range from 0.1 to 10.

9. Method of manufacturing an electronic device comprising a inverter unit with a first and a second field-effect transistor with a common active layer containing a functionalized organic n-type semi-conductor material and a functionalized organic p-type semi-conductor material, which active layer is applied to a substrate from a solution.

## Patentansprüche

1. Elektronische Anordnung mit einer Wechselrichtereinheit (10) mit einem ersten (11) und einem zweiten (12) Feldeffekttransistor, welche jeweils eine Source- (21, 21') und eine Drainelektrode (22, 22') aufweisen, wobei die Elektroden der Feldeffekttransistoren in der gleichen Elektrodenschicht (2) aus elektrisch leitendem Material vorgesehen sind und das Source- und Drainelektrodenpaar durch einen ersten Kanal (23) vom n-Leitfähigkeitstyp und durch einen zweiten Kanal (23') vom p-Leitfähigkeitstyp untereinander verbunden sind, wobei die Kanäle in einer aktiven Schicht vorgesehen sind, welche organisches Halbleitermaterial enthält und welche von dem ersten und dem zweiten Transistor gemeinsam genutzt wird, wobei jeder der Transistoren eine Gateelektrode (24, 24') aufweist, welche durch eine dielektrische Schicht (4) von den Kanälen getrennt ist.

2. Elektronische Anordnung nach Anspruch 1, **dadurch gekennzeichnet, dass** eine gemeinsame Gateelektrode für den ersten und den zweiten Transistor vorhanden ist.

3. Elektronische Anordnung nach Anspruch 1 oder 2, **dadurch gekennzeichnet, dass** die Drainelektroden des ersten und des zweiten Transistors gemeinsam genutzt werden.

4. Elektronische Anordnung nach Anspruch 3, **dadurch gekennzeichnet, dass** die Source- und Drainelektrode ein interdigitierendes Elektrodenpaar bilden, bei welchem die Sourceelektroden durch Zwischenteile der Drainelektrode gegenseitig geschützt sind.

5. Elektronische Anordnung nach Anspruch 4, **dadurch gekennzeichnet, dass** die Drainelektrode einen Körper mit einer ersten Seite und einer von dieser ersten Seite abgewandten, zweiten Seite aufweist, welcher auf der ersten Seite und der zweiten Seite fingerartige Strukturen besitzt, wobei die Sourceelektrode auf der ersten Seite vorgesehen ist und zusammen mit der fingerartigen Struktur auf dieser ersten Seite ein interdigitierendes Elektrodenpaar bildet, und wobei die Drainelektrode auf der zweiten Seite vorgesehen ist und zusammen mit der fingerartigen Struktur auf dieser zweiten Seite ebenfalls ein interdigitierendes Elektrodenpaar bildet.

6. Elektronische Anordnung nach Anspruch 1, **dadurch gekennzeichnet, dass** die aktive Schicht ein Gemisch aus einem organischen Trägermaterial, dem p-leitenden Halbleitermaterial und dem n-leitenden Halbleitermaterial enthält.

7. Elektronische Anordnung nach Anspruch 1, **dadurch gekennzeichnet, dass** die Source- und Drainelektrode ein aus der Gruppe von Edelmetallen ausgewähltes Material enthalten.

8. Elektronische Anordnung nach Anspruch 1, **dadurch gekennzeichnet, dass** das n- und p-leitende Halbleitermaterial eine Mobilität µₙ, µₚ in einem gegenseitigen Verhältnis im Bereich von 0,1 bis 10 aufweist.

9. Verfahren zur Herstellung einer elektronischen Anordnung mit einer Wechselrichtereinheit mit einem ersten und einem zweiten Feldeffekttransistor mit einer gemeinsamen aktiven Schicht, welche ein funktionalisiertes, organisches, n-leitendes Halbleitermaterial und ein funktionalisiertes, organisches, p-leitendes Halbleitermaterial enthält, wobei die aktive Schicht aus einer Lösung auf ein Substrat aufgetragen wird.

## Revendications

1. Dispositif électronique comprenant une unité inverseuse (10) avec un premier (11) et un deuxième transistor à effet de champ (12) qui comprennent chacun une électrode de source (21, 21') et une électrode de drain (22, 22'), lesquelles électrodes des transistors à effet de champ se situent dans la même couche d'électrode (2) constituée de matériau électriquement conducteur et laquelle paire d'électrodes de source et de drain est interconnectée par un premier canal (23) avec une conductivité du type n et par un deuxième canal avec une conductivité du type p (23'), lesquels canaux se situent dans une couche active qui contient du matériau semi-conducteur organique et qui est commune au premier et au deuxième transistor, chacun des transistors comprenant une électrode de grille (24, 24') qui est séparée des canaux par une couche diélectrique (4).

2. Dispositif électronique selon la revendication 1, **caractérisé en ce qu'**une électrode de grille commune est présente pour le premier et le deuxième transistor.

3. Dispositif électronique selon la revendication 1 ou 2, **caractérisé en ce que** les électrodes de drain du premier et du deuxième transistor sont communes.

4. Dispositif électronique selon la revendication 3, **caractérisé en ce que** les électrodes de source et de drain constituent une paire interdigitée d'électrodes, dans lesquelles les électrodes de source sont mutuellement protégées par des parties intermédiaires de l'électrode de drain.

5. Dispositif électronique selon la revendication 4, **caractérisé en ce que** l'électrode de drain comprend un corps avec un premier côté et avec un deuxième côté qui est détourné de ce premier côté, lequel corps du premier côté et du deuxième côté présente une structure en forme de doigts, l'électrode de source étant située du premier côté et constituant, concurremment avec la structure en forme de doigts de ce premier côté, une paire interdigitée d'électrodes et l'électrode de drain étant située du deuxième côté constituant aussi, concurremment avec la structure en forme de doigts de ce deuxième côté, une paire interdigitée d'électrodes.

6. Dispositif électronique selon la revendication 1, **caractérisé en ce que** la couche active contient un mélange constitué d'un matériau porteur organique, d'un matériau semi-conducteur du type p et d'un matériau semi-conducteur du type n.

7. Dispositif électronique selon la revendication 1, **caractérisé en ce que** l'électrode de source et l'électrode de drain comprennent un matériau qui est choisi parmi le groupe de métaux précieux.

8. Dispositif électronique selon la revendication 1, **caractérisé en ce que** les matériaux semi-conducteurs du type n et du type p présentent une mobilité µₙ, µₚ et une relation mutuelle µₙ:µₚ dans la gamme comprise entre 0,1 et 10.

9. Procédé de fabrication d'un dispositif électronique comprenant une unité inverseuse avec un premier et un deuxième transistor à effet de champ avec une couche active commune contenant un matériau fonctionnalisé semi-conducteur organique du type n et un matériau fonctionnalisé semi-conducteur organique du type p, laquelle couche active est appliquée, à partir d'une solution, sur un substrat.
